# FASCICULE DE BREVET EUROPEEN

(11) **EP 1 468 158 B1**
(45) Date de publication et mention de la délivrance du brevet: **06.06.2007**
(21) Numéro de dépôt: 02791853.1
(22) Date de dépôt: 19.12.2002
(51) Int. Cl.: E05B 65/20

(54) **POIGNEE D'OUVRANT AVEC CAPTEUR DE PRESENCE**
FAHRZEUGTÜRGRIFF MIT ANNÄHERUNGSSENSOR
DOOR HANDLE WITH PRESENCE SENSOR

(30) Priorité: 26.12.2001 FR 0116894
(43) Date de publication de la demande: 20.10.2004
(73) Titulaire: VALEO SECURITE HABITACLE, 94042 Creteil Cédex (FR)
(72) Inventeur: GEHIN, Frédéric, F-94000 CRETEIL (FR)
(74) Mandataire: Rosolen-Delarue, Katell
(86) Numéro de dépôt international: PCT/EP2002/014524
(87) Numéro de publication internationale: WO 2003/056118

(56) Documents cités:
- EP-A- 0 954 098
- EP-A- 1 164 240
- DE-A- 4 006 119

## Description

La présente invention concerne une poignée d'ouvrant notamment pour véhicule automobile.

L'invention concerne plus particulièrement une poignée d'ouvrant comportant des électrodes d'un capteur de présence d'un utilisateur et présentant des moyens conducteurs pour générer une zone de détection de présence utile de l'utilisateur.

L'invention est également relative à un système permettant ou empêchant l'accès à un véhicule automobile et intégrant une telle poignée.

Dans le domaine automobile, la poignée d'ouvrant qui servait dans le temps seulement pour transmettre un mouvement mécanique, par l'intermédiaire d'une tringlerie à une serrure, pour l'ouverture de l'ouvrant, a beaucoup évoluée.

En effet, en particulier pour les systèmes d'accès dits "mains libres" permettant le verrouillage et le déverrouillage d'un véhicule automobile sans clé mécanique ni télécommande, la poignée est devenue une interface privilégiée entre l'utilisateur portant un identifiant (par exemple sous la forme d'un badge) et le système embarqué sur le véhicule.

Avec ces systèmes d'accès mains libres, il est devenu nécessaire de définir de nouveaux systèmes et de nouvelles poignées permettant la détection de présence d'un utilisateur souhaitant notamment accéder à son véhicule.

Cette détection est classiquement réalisée grâce à deux électrodes placées au niveau de poignée et reliée à un circuit d'alimentation électrique.

Le couplage électromagnétique qui s'établit entre les deux électrodes génère des lignes de champs qui définissent une zone de détection de présence de l'utilisateur au niveau de la poignée. Ainsi, lorsque l'utilisateur approche sa main de la poignée en vue d'accéder à son véhicule, sa présence est détectée et , dans le cadre d'un accès mains libres, son identification, par communication entre le véhicule et l'identifiant porté par l'utilisateur, est initiée. Une telle poignée est par exemple connue de EP-A-0 954 098.

Dans de telles poignées, la localisation de la zone de détection dépend du positionnement relatif des électrodes sur la poignée.

Le document EP-A-1 164 240 décrit une poignée d'ouvrant pour véhicule automobile comprenant une électrode de mesure et une electrode de référence d'un capteur de présence d'un utilisateur, lesdits électrodes étant toutes deux reliées à un circuit d'alimentation electrique et dans laquelle la zone de détection est améliorée par un conducteur faisant écran.

Dans certaines architectures de poignées, il n'est pas possible de positionner les électrodes de mesure et de référence de manière idéale pour que leur couplage génère une zone de détection tout à fait adaptée à l'architecture de la poignée.

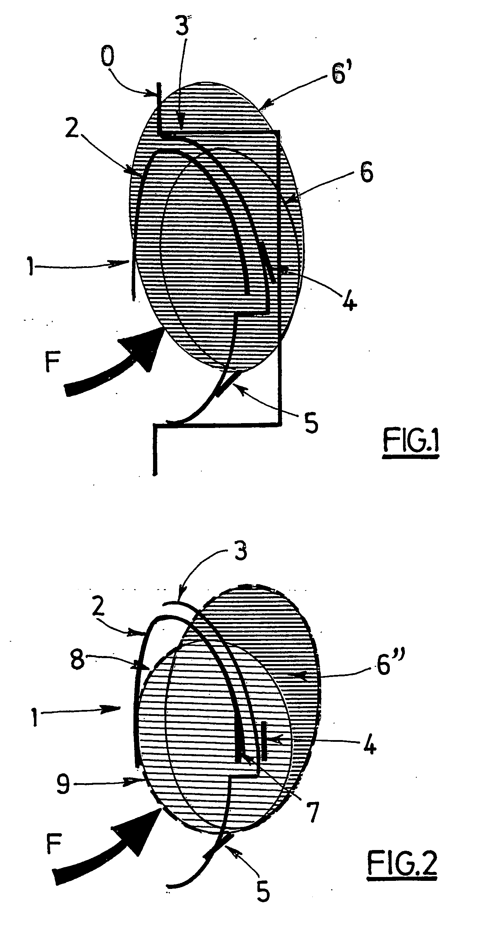

Ce problème est représenté à la figure 1, montrant schématiquement une coupe en élévation d'une poignée 1 de type « palette ». Ladite poignée 1 est positionnée au niveau d'un ouvrant O et composée d'une partie de préhension 2 et d'une partie fixe 3. La partie de préhension 2 est mobile par rapport à la partie fixe 3 selon un axe de pivotement.

Dans une telle poignée, pour obtenir une zone de détection adaptée, un positionnement idéal des électrodes consisterait à placer l'une des électrodes au niveau de la partie fixe et l'autre au niveau de la partie de préhension

Cependant, cela génère des problèmes notamment au niveau de la connectique de l'électrode se trouvant sur la partie de préhension.

En conséquence, on positionne les électrodes comme représenté sur la figure 2 dans laquelle une électrode de mesure 4 et une électrode de référence 5 sont positionnées au niveau de la partie fixe 3 de la poignée.

La zone de détection de présence de l'utilisateur induite par la présence de lignes de champs générées par l'établissement d'un couplage électromagnétique entre les deux électrodes 4 et 5 est référencée 6 sur la figure.

On constate que cette zone n'est pas assez étendue pour que la détection de l'utilisateur, lorsqu'il approche sa main de la poignée selon la flèche F, se fasse de manière suffisamment anticipée.

En effet, lorsque le véhicule ne détecte pas la présence de l'utilisateur suffisamment tôt, l'ouvrant n'est pas encore déverrouillé alors que l'utilisateur a terminé d'actionner la poignée. L'utilisateur est alors être confronté à un « effet de mur ».

En conséquence, l'identification de l'utilisateur et le déverrouillage des serrures du véhicule doit se faire dans un temps très court de durée inférieure au temps d'actionnement de la poignée.

Une solution serait d'augmenter la sensibilité du capteur de présence. Cependant lorsque la sensibilité du capteur est augmentée, la zone de détection de présence qui lui est associée devient alors trop importante selon une certaine direction. Cette zone de détection est référencée 6' sur la figure 1.

On constate que l'augmentation de la sensibilité du capteur ne permet pas d'agrandir la zone de détection dans la direction d'approche de la main de l'utilisateur.

Par ailleurs, l'augmentation de la sensibilité du capteur peut augmenter les risques de fausses détections lorsque la zone d e détection qui lui est associée s'étend au delà de la poignée vers l'extérieur comme c'est le cas dans la figure 1. Les intempéries ou le passage d'une personne à proximité du véhicule peuvent déclencher le système de façon intempestive.

Un but de la présente invention est de pallier ces inconvénients et de proposer une solution d'améliorer la zone de détection créer par deux électrodes positionnées non idéalement au niveau de la poignée.

A cet effet, l'invention a pour objet une poignée d'ouvrant, notamment pour véhicule automobile comprenant, une électrode de mesure et une électrode de référence d'un capteur de présence d'un utilisateur, lesdites électrodes étant toutes deux reliées à un circuit d'alimentation électrique.

Cette poignée se caractérise par le fait qu'elle comprend, en outre, des moyens conducteurs localisés de manière isolée sans liaison physique avec d'autres éléments conducteurs ou avec le circuit d'alimentation électrique et positionnés au moins partiellement en regard de l'une desdites électrodes pour établir un couplage capacitif, la taille et la forme desdits moyens conducteurs étant choisis de sorte que, lesdits moyens conducteurs, l'électrode de mesure et l'électrode de référence génèrent par couplage électromagnétique une zone de détection de présence utile de l'utilisateur.

On entend par zone de détection utile, une zone optimisée permettant de réaliser la détection de l'approche de l'utilisateur de manière aussi anticipée que possible sans augmenter le risque de fausses détections.

Selon un mode de réalisation préférentiel de l'invention, l'électrode en regard de laquelle sont positionnés les moyens conducteurs est fixée sur ou intégrée à la partie fixe de la poignée et les moyens conducteurs sont intégrés ou fixés au niveau de la partie de préhension de la poignée, de manière à ce que le passage de la poignée dans sa position d'ouverture génère une modification du couplage capacitif.

Ainsi, en cas de non détection de l'approche de la main de l'utilisateur en direction de la poignée, il est possible d'assurer une détection de secours lorsqu'il actionne la poignée.

Avantageusement, les moyens conducteurs sont surmoulés dans la partie de préhension de la poignée.

L'invention a également pour objet un système permettant ou empêchant l'accès à un véhicule automobile et comportant une poignée d'ouvrant selon l'invention.

L'invention sera mieux comprise au cours de la description explicative détaillée d'un exemple non limitatif faisant référence aux figures annexées qui représentent :
- Figure 1, une vue en coupe transversale d'une poignée selon l'art antérieur ;
- Figure 2, une vue e n coupe transversale illustrant la zone de détection de présence utile obtenue selon un mode de réalisation de l'invention ;
- Figure 3, une vue en coupe transversale de la poignée de la figure 2 lors de son actionnement par un utilisateur ;
- Figure 4, une vue de face d'une poignée conforme à l'invention dans laquelle le capteur de présence est un capteur de présence tactile ;
- Figure 5, une vue en perspective éclatée et simplifiée du capteur tactile de la figure 4.

La figure 2 présente une vue schématique en coupe transversale d'une poignée selon un mode de réalisation préféré de l'invention. Tout comme dans le cas de la figure 1, la poignée 1 se compose d'une partie de préhension 2 et d'une partie fixe 3 positionnée sur un ouvrant (non représenté). Des électrodes de mesure 4 et de référence 5 d'un capteur de présence (non représenté) sont localisées au niveau de la partie fixe 3 de la poignée. Les électrodes de mesure 4 et de référence 5 sont toutes deux reliées à un circuit d'alimentation électrique (non représenté) de telle sorte qu'il s'établit entre ces électrodes un couplage électromagnétique. Ce couplage électromagnétique génère des lignes de champs qui permettent de définir une première zone de détection de présence non représentée sur la figure 2 mais similaire à la zone de détection de présence 6 de la figure 1. Comme on peut le constater sur la figure 1, cette zone de détection de présence 6 n'englobe pas totalement la zone située entre la partie de préhension 2 et la partie fixe 3. Il en résulte que lorsque l'utilisateur approche sa main dans la direction de la flèche F, il existe soit un risque de non détection soit un risque « d'effet de mur ».

Dans le but d'obtenir une zone de détection de présence optimisée, la poignée 1 de la figure 2 présente également, selon l'invention, des moyens conducteurs 7, réalisés sous la forme d'un élément métallique, positionnés au moins partiellement en regard de l'électrode de mesure 4. Les moyens conducteurs 7 sont localisés de manière isolée, c'est à dire sans liaison physique avec d'autres éléments conducteurs ou avec le circuit d'alimentation électrique.

Grâce à cette disposition particulière, il s'établit, entre l'électrode de mesure 4 et les moyens conducteurs 7, un couplage capacitif provoquant une modification de la répartition initiale des lignes de champ établies entre l'électrode de mesure 4 et l'électrode de référence 5.

Il en résulte une zone de détection de présence 6" dont la forme est modifiée par rapport à la zone de détection de présence 6 de la figure 1.

Par ailleurs, les moyens conducteurs 7 génèrent par couplage électromagnétique avec l'électrode de référence 5 des lignes de champs intermédiaires. Ces lignes de champs intermédiaires viennent définir une seconde zone de détection de présence 8 de l'utilisateur.

Comme cela est visible sur la figure 2, la seconde zone de détection de présence 8 est de taille plus faible que la zone de détection de présence 6" et légèrement décalée par rapport à celle-ci.

Dans le cas présent, les première et seconde 8 zones de détection de présence 6 " et 8 se recouvrent d e manière importante. L'union de ces deux zones permet de définir une zone de détection utile 9 de l'utilisateur, représentée en traits pointillés sur la figure 2, grâce à laquelle on peut réaliser la détection de l'approche de l'utilisateur de manière aussi anticipée que possible sans augmenter le risque de fausses détections.

Cette zone de détection de présence utile 9 présente une taille supérieure à la première zone de détection de présence 6" et correspond à une zone de détection optimisée par rapport à l'architecture de la poignée 1.

Ainsi, on joue sur les caractéristiques géométriques et dimensionnelles des moyens conducteurs 7 pour générer une zone de détection optimisée par rapport à l'architecture de la poignée.

Selon l'architecture de la poignée, il est également possible d'aboutir au même résultat, c'est à dire à la création d'une zone de détection utile optimisée par rapport à l'architecture de la poignée, en réalisant un couplage entre des moyens conducteurs et l'électrode de référence.

Dans ce mode de réalisation, les moyens conducteurs ont été positionnés au niveau de la partie de préhension 2 de la poignée mais, en fonction de l'architecture de la poignée, ils peuvent, de la même manière, être localisés au niveau de la partie fixe 3 de la poignée.

Cependant, le fait que les moyens conducteurs 7 soient positionnés sur la partie de préhension 2 de la poignée et que l'électrode en regard de laquelle ces moyens sont positionnés soit sur la partie fixe 3 présente un autre avantage.

En effet, dans certains cas particuliers, la présence de l'utilisateur peut ne pas être détectée lorsqu'il approche sa main de la poignée, par exemple parce qu'il porte des gants. Il devient alors nécessaire de recourir à une détection de secours.

La localisation particulière des moyens conducteurs sur la partie de préhension mobile permet cette détection de secours.

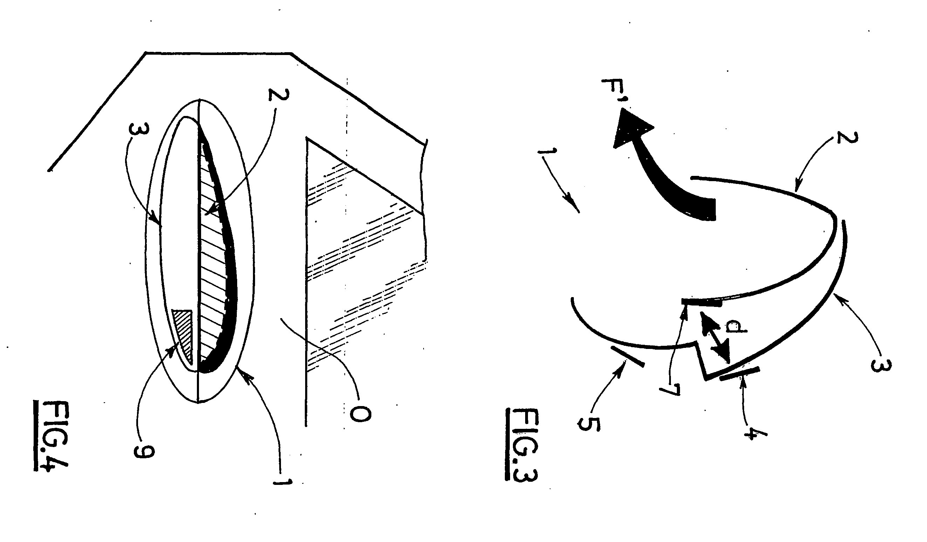

En effet, comme représenté sur la figure 3, lorsque l'utilisateur actionne, dans la direction de la flèche noire F', la partie de préhension 2 de la poignée 1 pour ouvrir l'ouvrant du véhicule, les moyens conducteurs 7 sont éloignés de l'électrode de mesure 4 en regard de laquelle il se trouve d'une distance d.

Cette augmentation de distance entraîne une diminution du couplage capacitif existant entre ces deux éléments et modifie la répartition des lignes de champ existant entre l'électrode de mesure et l'électrode de référence.

La capacité vue par le capteur est alors réduite, cette réduction étant interprétée, par le capteur, comme la présence d'un utilisateur. Un signal de détection est donc généré.

Les moyens conducteurs sont fixés, par tous moyens de fixation connus, sur la partie de préhension de la poignée mais peuvent également être directement surmoulés avec la partie de préhension de la poignée lors de sa fabrication.

L'invention a été décrite notamment pour une application à la détection, par le capteur de détection de présence, de l'approche d'un utilisateur au niveau de la poignée en particulier pour des systèmes de détection de présence d'un utilisateur.

Comme présenté, la détection de présence de l'approche d'un utilisateur au niveau de la poignée permet de réaliser la commande d'au moins une fonction donnée au niveau du véhicule et notamment le déverrouillage du véhicule après identification de l'utilisateur, l'identification étant initiée par la détection de la présence de l'utilisateur au niveau de la poignée.

On a maintenant présenté en référence à la figure 4, un autre mode de réalisation d'une poignée selon l'invention dans laquelle le capteur de présence est un capteur tactile.

Ce capteur tactile, positionné au niveau de la poignée, permet, par détection d'une action de toucher de l'utilisateur, de commander une fonction particulière au niveau du véhicule et notamment le verrouillage de ce dernier.

A la différence du capteur d'approche présenté dans les figures précédentes, la zone de détection utile 9 est ici une zone de surface localisée sur la poignée.

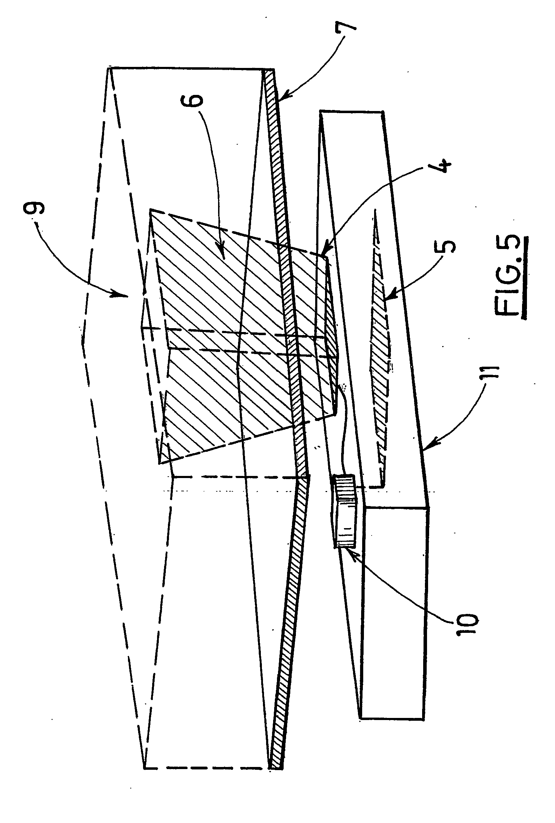

La figure 5 présente une vue en perspective éclatée et simplifiée, de l'agencement spatial de ce capteur tactile.

Le capteur tactile de ce nouvel agencement comporte classiquement un circuit d'alimentation électrique 10 positionné sur un circuit imprimé 11 auquel sont reliées une électrode de mesure 4 et une électrode de référence 5.

L'électrode de mesure 4 est située sur la face supérieure du circuit imprimé et est positionnée en regard de l'électrode de référence 5 qui est située sur la face inférieure du circuit imprimé 11.

Selon l'invention, des moyens conducteurs 7 sont positionnés en regard de l'électrode de mesure 4 ce qui permet de générer une zone de détection utile 9. En effet, par l'introduction de moyens conducteurs 7 en regard et à proximité de l'électrode de mesure 4, il s'établit un couplage capacitif entre ces deux éléments. Ce couplage capacitif vient modifier la répartition existante des lignes de champs établies entre l'électrode de mesure 4 et l'électrode de référence 5. Une nouvelle répartition des lignes de champs s'établit donc entre l'électrode de mesure 4 et l'électrode de référence 5 d'une part et les moyens conducteurs 7 et l'électrode de référence 5 d'autre part.

Dans un structure de type « sandwich », les lignes de champ s'établissent très majoritairement entre l'électrode de référence 5 et les moyens conducteurs 7.

A des fins de comparaison, on a représenté également sur la figure 5 la zone de détection 6 qui aurait été générée par couplage électromagnétique entre les électrodes de mesure 4 et de référence 5 si la poignée ne présentait pas les moyens conducteurs 7.

Cette zone de détection de présence 6 représentée sous la est de taille limitée et se trouve située dans le prolongement des électrodes au dessus de l'électrode de mesure. Elle présente une forme évasée dont la base est dépendante de la forme de l'électrode de mesure.

Grâce aux moyens conducteurs 7, on constate que la zone de détection utile 9 est de taille plus importante que la zone de détection 6 et présente une base dont la taille et la forme sont dépendantes des caractéristiques géométriques et dimensionnelles des moyens conducteurs 7.

Dans le cas présent, la zone de détection utile 9 correspond à la zone de détection associée au couplage électromagnétique entre les moyens conducteurs 7 et l'électrode de référence 5 du fait que l'électrode de référence 5 est positionnée en regard de l'électrode de mesure 4.

Selon l'invention, les moyens conducteurs peuvent être assimilés à une électrode de déport permettant, par couplage capacitif avec l'électrode en regard de laquelle elle est positionnée, de déporter une partie des lignes de champ pour venir créer une zone de détection de présence utile de l'utilisateur.

Grâce à l'invention, on peut ainsi réaliser une poignée comportant un capteur de présence (tactile ou approche) pour laquelle la zone de détection est optimisée et fonction de son architecture.

La poignée selon l'invention est généralement intégrée au niveau d'un véhicule et peut être mis en oeuvre dans un système de détection de présence d'un utilisateur pour la commande d'au moins une fonction au niveau du véhicule.

Grâce à l'invention, il est possible de commander le verrouillage et/ou le déverrouillage d'au moins un ouvrant de véhicule et d'associer éventuellement cette commande à un véhicule à accès mains libres.

## Revendications

1. Poignée d'ouvrant, notamment pour véhicule automobile, comprenant une électrode de mesure (4) et une électrode de référence (5) d'un capteur de présence d'un utilisateur, lesdites électrodes étant toutes deux reliées à un circuit d'alimentation électrique (10),
**caractérisée en ce qu'**elle comprend, en outre, des moyens conducteurs, (7) localisés de manière isolée sans liaison physique avec d'autres éléments conducteurs ou avec le circuit d'alimentation électrique et positionnés au moins partiellement en regard de l'une desdites électrodes (4, 5) pour établir un couplage capacitif, la taille et la forme desdits moyens conducteurs (7) étant choisis de sorte que, lesdits moyens conducteurs (7), l'électrode de mesure (4) et l'électrode de référence (5) génèrent par couplage électromagnétique une zone de détection de présence utile (9) de l'utilisateur.

2. Poignée d'ouvrant selon la revendication 1, **caractérisée en ce** la poignée comprend une partie de préhension (2) mobile par rapport à l'ouvrant et destinée à être actionnée entre une position de repos et une position d'ouverture par l'utilisateur ainsi qu'une partie fixe (3) positionnée sur l'ouvrant, en ce que l'électrode (4,5) en regard de laquelle sont positionnés les moyens conducteurs (7) est fixée sur ou intégrée à la partie fixe (3) de la poignée et en ce que les moyens conducteurs (7) sont intégrés ou fixés au niveau de la partie de préhension (2) de la poignée, de manière à ce que le passage de la poignée de sa position de repos à sa position d'ouverture génère une modification du couplage capacitif.

3. Poignée d'ouvrant selon la revendication 2, **caractérisée en ce que** les moyens conducteurs (7) sont surmoulés dans la partie de préhension (2) de la poignée.

4. Poignée d'ouvrant selon l'une quelconque des revendications précédentes **caractérisée en ce qu'**elle fait partie d'un système de détection de présence d'un utilisateur au niveau de la zone de détection de présence utile (9) pour réaliser la commande d'au moins une fonction donnée au niveau du véhicule.

5. Système permettant ou empêchant l'accès à un véhicule automobile **caractérisé en ce qu'**il comporte une poignée d'ouvrant selon l'une quelconque des revendications 1 à 4.

## Claims

1. Door handle, notably for an automobile vehicle, including a measuring electrode (4) and a reference electrode (5) of a user presence sensor, both electrodes being connected to an electrical power supply circuit (10),
**characterized in that** it also includes conducting means (7) fitted in an insulated manner without any physical link with other conducting parts or with said electrical power supply circuit and positioned at least partially facing said electrodes (4, 5) to establish a capacitive coupling, the size and shape of said conducting means (7) being chosen such that said conducting means (7), said measuring electrode (4) and said reference electrode (5) generate by electromagnetic coupling an effective user presence detection zone (9).

2. Door handle according to claim 1, **characterized in that** said handle includes a gripping part (2) that is mobile relative to the door and intended to be moved between a rest position and an opening position by the user, and a fixed part (3) positioned on the door, **in that** said electrode (4,5) facing said conducting means (7) is fixed on or integrated in said fixed part (3) of the handle, and **in that** said conducting means (7) are integrated in or fixed on said gripping part (2) of the handle such that the movement of the handle from its rest position to its opening position causes a modification of the capacitive coupling.

3. Door handle according to claim 2, **characterized in that** said conducting means (7) are overmoulded onto said gripping part (2) of the handle.

4. Door handle according to any of the preceding claims, **characterized in that** it is part of a system able to detect the presence of a user in said user presence detection zone (9) in order to control at least one given function in the vehicle.

5. System enabling or preventing access to an automobile vehicle, **characterized in that** it includes a door handle according to any of claims 1 to 4.

## Patentansprüche

1. Türgriff, insbesondere für Kraftfahrzeuge, mit einer Messelektrode (4) und einer Bezugselektrode (5) eines Sensors zum Erfassen der Anwesenheit eines Benutzers, wobei die Elektroden beide mit einem Speisestromkreis (10) verbunden sind, **dadurch gekennzeichnet, dass** er ferner leitfähige Mittel (7) aufweist, die isoliert und ohne physische Verbindung mit anderen leitenden Elementen oder mit dem Speisestromkreis angeordnet sind und zumindest teilweise einer der Elektroden (4, 5) gegenüberliegen, um eine kapazitive Kopplung zu schaffen, wobei die Größe und die Form der leitfähigen Mittel (7) derart gewählt sind, dass die leitfähigen Mittel (7), die Messelektrode (4) und die Bezugselektrode (5) durch elektromagnetische Kopplung eine Nutzzone (9) zum Erfassen der Anwesenheit des Benutzers erzeugen.

2. Türgriff nach Anspruch 1, **dadurch gekennzeichnet, dass** der Griff einen Greifabschnitt (2) aufweist, der bezüglich der Tür beweglich und dazu bestimmt ist, von dem Benutzer zwischen einer Ruhestellung und einer Öffnungsstellung betätigt zu werden, sowie einen an der Tür positionierten festen Abschnitt (3), dass die Elektrode (4, 5), gegenüber welcher die leitfähigen Mittel (7) positioniert sind, an dem festen Abschnitt (3) des Griffs befestigt bzw. darin integriert ist und dass die leitfähigen Mittel (7) im Bereich des Greifabschnitts (2) des Griffs so integriert bzw. befestigt sind, dass der Übergang des Griffs von seiner Ruhestellung in seine Öffnungsstellung eine Änderung der kapazitiven Kopplung bewirkt.

3. Türgriff nach Anspruch 2, **dadurch gekennzeichnet, dass** die leitfähigen Mittel (7) in den Greifabschnitt (2) des Griffs eingegossen sind.

4. Türgriff nach einem der vorangehenden Ansprüche, **dadurch gekennzeichnet, dass** er zu einem System zum Erfassen der Anwesenheit eines Benutzers im Bereich der Anwesenheiterfassungsnutzzone (9) gehört, um im Bereich des Fahrzeugs die Steuerung zumindest einer gegebenen Funktion durchzuführen.

5. System zum Gestatten bzw. Verhindern des Zugangs zu einem Kraftfahrzeug, **dadurch gekennzeichnet, dass** es einen Türgriff nach einem der Ansprüche 1 bis 4 aufweist.
